# EUROPEAN PATENT APPLICATION

(11) **EP 0 598 711 A2**
(43) Date of publication of application: **25.05.1994**
(21) Application number: 94200376.5
(22) Date of filing: 29.11.1989
(51) Int. Cl.: H01L 29/812, H01L 29/08

(54) **MESFET source/drain structure**

(30) Priority: 12.04.1989 JP 93577/89
(62) Divisional of application: 89312417.2
(71) Applicant: MITSUBISHI DENKI KABUSHIKI KAISHA, Tokyo (JP)
(72) Inventor: Oku, Tomoki, c/o Mitsubishi Denki Kabushiki Kaisha, Itami-shi, Hyogo-ken (JP)
(74) Representative: Beresford, Keith Denis Lewis

(57) **Abstract**

A transistor (fig. 1(i)) having a refractory metal gate (3) on a semi-insulating compound semiconductor substrate (1), asymmetrical side walls (5',7') each side of the gate (3), a low concentration active channel (2) below the gate (3),
source and drain high concentration active regions (8a,8b) each side of the channel (2), and asymmetric intermediate concentration active regions (4a',4b') between source (8a) and channel (2), and channel (2) and drain (8b), respectively, beneath the asymmetrical side walls (5',7'). The side walls (5',7') may be removed.

## Description

### FIELD OF THE INVENTION

The present invention relates to a semiconductor device and a production method thereof, and more particularly to a Schottky barrier gate type field effect transistor utilizing a Schottky barrier for the gate in which a high concentration active layer which is asymmetrical with respect to the gate is produced by self-aligning method.

### BACKGROUND OF THE INVENTION

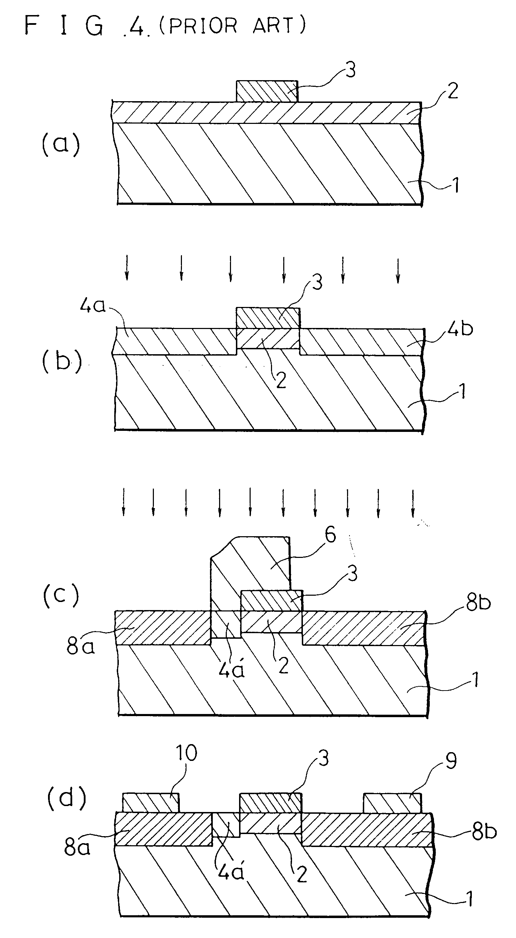

Figures 4(a) to (d) are cross-sectional side views showing major process steps for producing a semiconductor device according to the prior art. In figure 4, reference numeral 1 designates a semi-insulating GaAs substrate. An n type active layer 2 is produced on the semi-insulating GaAs substrate 1. A gate electrode 3 comprising refractory metal is produced on the active layer 2. N' type intermediate concentration active layers (hereinafter referred to as "n' layer") 4a (4a') and 4b are produced at the n type active layer 2. N⁺ type high concentration active layers (hereinafter referred to as "n⁺ layer") 8a and 8b are produced at the n type active layer 2. A source electrode 9 and a drain electrode 10 are produced on the n⁺ layers 8a and 8b, respectively. Reference numeral 6 designates photoresist.

The production method will be described.

First of all, as shown in figure 4(a), an n type active layer 2 is produced on a semi-insulating GaAs substrate 1 by ion implantation or epitaxy growth, and thereafter, a refractory metal is plated on the entire surface of wafer and patterned by a reactive ion etching with using photoresist as a mask, thereby to produce a refractory metal gate electrode 3.

Next, as shown in figure 4(b), ion implantation is conducted with using the refractory metal gate electrode 3 as a mask, whereby n' layers 4a and 4b are produced at the both sides of the gate electrode 3.

Next, as shown in figure 4(c), photoresist is plated on the entire surface of substrate and patterned in an asymmetrical configuration with respect to the refractory metal gate electrode 3, and ion implantation is conducted with using the patterned photoresist 6 as a mask, whereby n⁺ layers 8a and 8b are produced at asymmetrical positions with respect to the gate electrode 3.

Thereafter, an annealing process is conducted, and further, as shown in figure 4(d), a drain electrode 10 is produced on the n⁺ layer 8a at the side where the n' layer 4a' is remaining and a source electrode 9 is produced on the n⁺ layer 8b at the opposite side by vapor deposition and lift-off method, thereby completing a field effect transistor.

In the above-described production method, however, the ion implantation for producing the n⁺ layers 8a and 8b have to be conducted by using the photoresist 6 as a mask, and the distance between the gate electrode 3 and the n⁺ layer 8a below the drain electrode 10 is determined by the precision of patterning. Therefore, in the field effect transistor obtained by the above-described production method, the variation of the gate-drain breakdown voltage is large as well as there may arise variation in the performances of the transistor. Furthermore, since the distance between the gate electrode 3 and the n⁺ layer 8b at the side of source electrode 9 is zero, a sufficient breakdown voltage cannot be obtained.

Another prior art production method will be described.

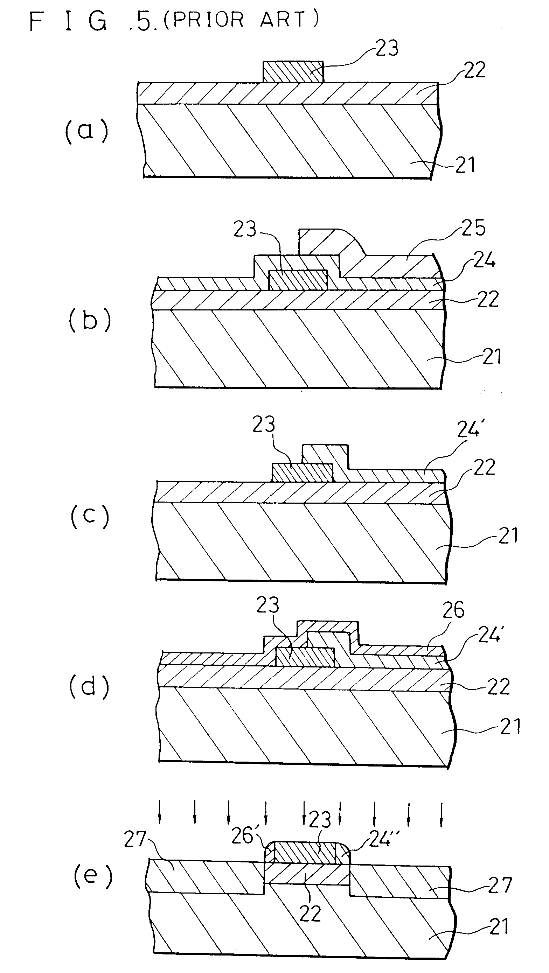

Figures 5(a) to (e) are cross-sectional side views showing major process steps for producing a semiconductor device disclosed in Japanese Laid-open Patent Publication No. Sho 63-107071. In figure 5, reference numeral 21 designates a semiconductor substrate. An active region 22 is produced on the semiconductor substrate 21. A gate electrode 23 is produced on the active region 22. A first insulating film 24 (24', 24'') is produced on the active region 22. Reference numeral 25 designates photoresist. Reference numeral 26 (26') designates a second insulating film. Reference numeral 27 designates a contact region.

The production method will be described.

First of all, as shown in figure 5(a), an active region 22 and a gate 23 are produced on the GaAs substrate 21, and thereafter, a first insulating film 24 having a thickness t₁ is plated thereon. Thereafter, photoresist is plated on the entire surface, and an exposure development processing is conducted thereto, thereby to obtain a photoresist 25 having a configuration as shown in figure 5(b). Subsequently, as shown in figure 5(c), a portion of the oxide film 24 is removed by diluted solution of fluoric acid with using the photoresist 25 as a mask. Thereafter, as shown in figure 5(d), after removing the photoresist 25, a second insulating film 26 having thickness t₂ is plated on the entire surface. Then, as shown in figure 5(e), the entire surface is selectively etched thereby to produce asymmetric configuration side walls 24'' and 26' at the both sides of the gate 23, and contact regions 27 are produced by ion beam implantation with using the side walls 24'', 26' and the gate 23 as a mask. The contact regions 27 are produced to be of asymmetric configurations with respect to the gate 23 by self-alignment due to the difference between the thickness of the side wall 24'' and that of the side wall 26'.

In such field effect transistor, a predetermined distance is provided between the gate 23 and the both contact layers 27, and therefore, high gate-drain breakdown voltage can be obtained and the leakage between the gate and the source side contact layer 27 can be prevented.

In the prior art production method of a semiconductor device, however, the following problems arise in the actual production steps.

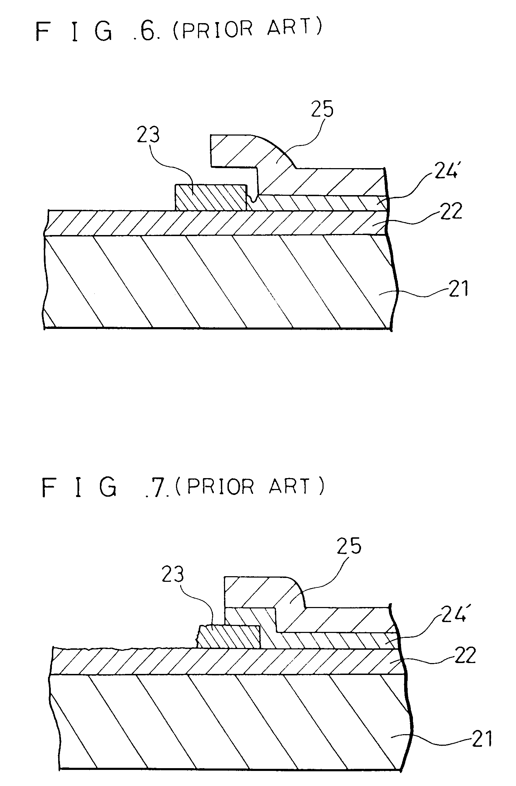

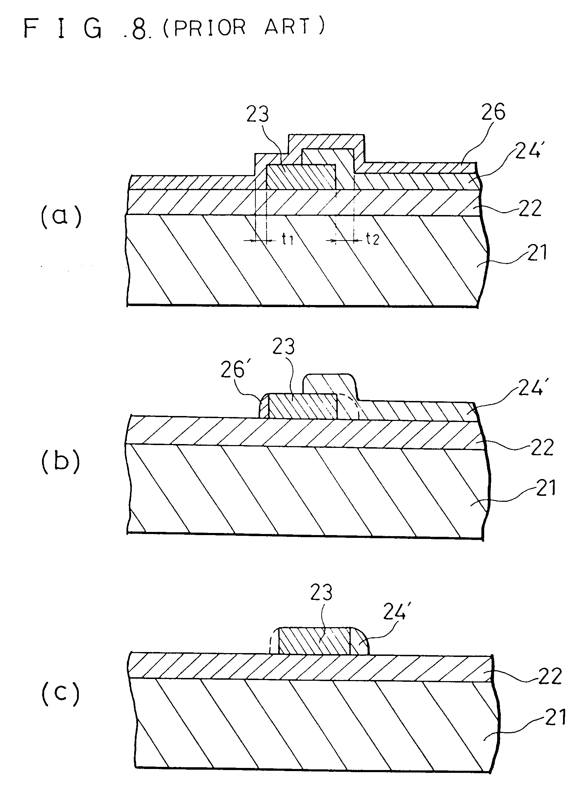

Firstly, in the process of removing the insulating film 24 at the gate side by wet etching with using the photoresist 25 as a mask, as shown in figure 6, since there is no anisotropicity in the etching, the photoresist 25 is peeled off by the side etching, and the etching proceeds up until reaching the first insulating film 24' below the photoresist 25. Even if this etching is conducted by dry etching, the etching selectivity of the first insulating film 24 against the gate 23 and GaAs substrate 2 is about 1 : 10, and it is difficult to remove only the first insulating film 24 by the etching. Therefore, as shown in figure 7, the surface of substrate and the side wall of gate 23 are also etched at the same time thereby to result in receiving damages, thereby arising variations in the gate length and reductions of active layer 22 in the substrate 21. This results in variations and deteriorations in the FET performances.

Secondly, in the process of producing side wall insulating films 24'' and 26' which are asymmetrical at left and right with respect to the gate 23 by RIE, the film thickness of the insulating film is different at left and right of the gate 23 as t₁ : (t₁ + t₂) as shown in figure 8(a), and the time which is required for just etching is differentiated. Therefore, as shown in figure 8(b), when the insulating film 26' is produced at the side wall of the gate 23, a first insulating film 24' still remains on the active layer 22 and on a portion of the gate 23.
Accordingly, if the insulating film 24' is further etched up until a side wall insulating film 24'' comprising the first insulating film 24' is of a desired configuration, the side wall insulating film 26' comprising the second insulating film which has already been produced would be almost gone. Thus, a desired side wall insulating film having an asymmetrical configuration will not be obtained, thereby increasing the variation of the gate-drain breakdown voltage. Furthermore, there arise leakages between the gate and source region, thereby deteriorating the FET performances. Furthermore, in this process, the active layer 22 and the gate 23 at the side where the side wall insulating film 26' is produced will receive damages by etching, thereby deteriorating the FET performances to a great extent.

### SUMMARY OF THE INVENTION

It is an object of the present invention to provide a semiconductor device constituting a refractory metal self-aligned transistor capable of reducing the variation in the gate-drain breakdown voltage and the variation in the transistor performances, and also capable of obtaining a sufficient gate-source breakdown voltage at high precision and at high reproducibility.

Another object of the present invention is to provide a method for producing such a semiconductor device.

Other objects and advantages of the present invention will become apparent from the detailed description given hereinafter; it should be understood, however, that the detailed description and specific embodiment are given by way of illustration only, since various changes and modifications within the spirit and scope of the invention will become apparent to those skilled in the art from this detailed description.

According to an aspect of the present invention, a semiconductor device is provided with a gate electrode comprising refractory metal provided on a semi-insulating compound semiconductor substrate where a low concentration active layer is produced, side wall assist films in asymmetrical configurations at left and right provided at the side walls of gate electrode, and high concentration active regions provided at positions asymmetrical with respect to the gate. Therefore, the variations in the transistor performances such as the drain-gate breakdown voltage and source-gate breakdown voltage can be reduced, and a high efficiency self-aligned field effect transistor can be obtained at high precision.

According to another aspect of the present invention, in the semiconductor device of above-described configuration, an intermediate concentration active region is produced at below the side wall assist film, and the high concentration active region is produced adjacent the intermediate concentration active region, thereby producing an LDD structure. Therefore, the variations in the drain-gate voltage can be further reduced, and furthermore, the short channel effect can be prevented.

According to a still another aspect of the present invention, a production method of a semiconductor device includes process steps of producing a gate electrode comprising refractory metal on a low concentration active region produced at a desired position of a semi-insulating compound semiconductor substrate, plating a first insulating film and entirely etching the first insulating film thereby to remain first side wall assist films at the both sides of gate electrode, removing the first side wall assist film at the side of gate electrode where a source electrode is to be produced with using photosensitive resin as a mask by wet etching, plating a second insulating film having a less thickness than that of the first insulating film, producing a second side wall assist film having a narrower width than that of the first side wall assist film at the side wall of the gate electrode where a source electrode is to be produced by conducting entire surface etching, and conducting ion implantation with using the first and second side wall assist films and the gate electrode as a mask thereby producing high concentration active regions having asymmetrical configurations at left and right at the both sides of gate electrode. Therefore, the first and second side wall assist films can be produced at the side walls of gate electrode at high controllability and high reproducibility.

According to a still another aspect of the present invention, the above-described production method of semiconductor device further includes a process of producing intermediate concentration active layers at the both sides of gate electrode by conducting ion implantation with using the gate electrode as a mask, which is executed between the process of producing the gate electrode on the low concentration active region and the process of plating the first insulating film.

### BRIEF DESCRIPTION OF THE DRAWINGS

Figures 1(a) to (i) are cross-sectional side views in the major process steps of a production method of a semiconductor device according to a first embodiment of the present invention;
Figures 2(a) and (b) are diagrams for explaining the precision of patterning in the first embodiment;
Figure 3 is a diagram showing a method of controlling the distance between the gate and n⁺ type high concentration active layer and the stability thereof in the first embodiment;
Figures 4(a) to (d) are cross-sectional side views of the major process steps of a production method of a semiconductor device according to a first prior art;
Figures 5(a) to (e) are cross-sectional side views of major process steps of a production method of a semiconductor device according to a second prior art; and
Figure 6, figure 7, and figures 8(a) to (c) are diagrams for explaining the problems in the second prior art.

### DETAILED DESCRIPTION OF THE PREFERRED EMBODIMENT

An embodiment of the present invention will be described in detail with reference to the drawings.

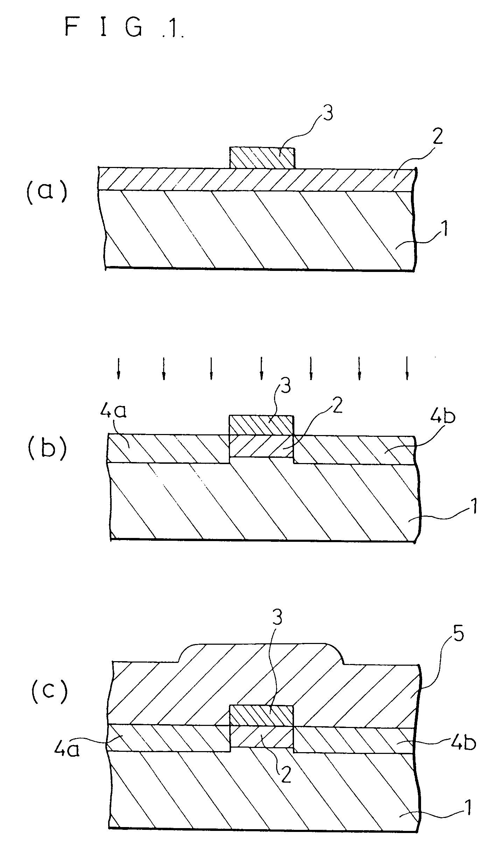

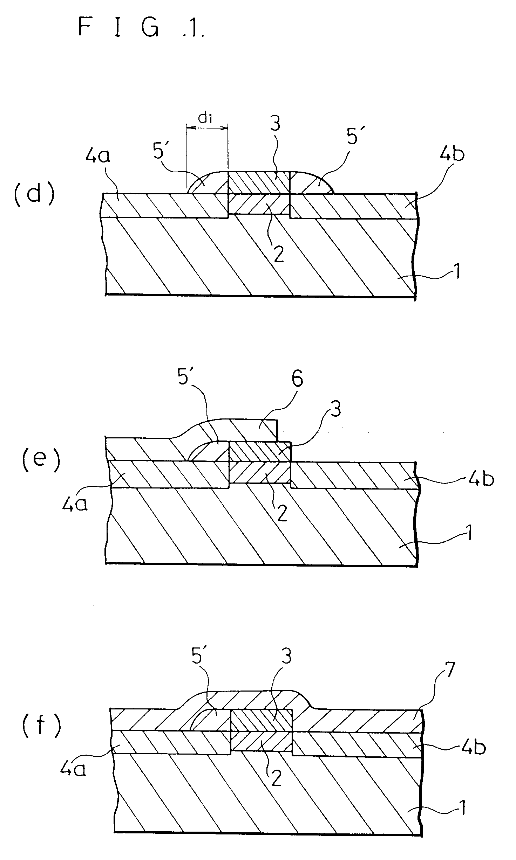

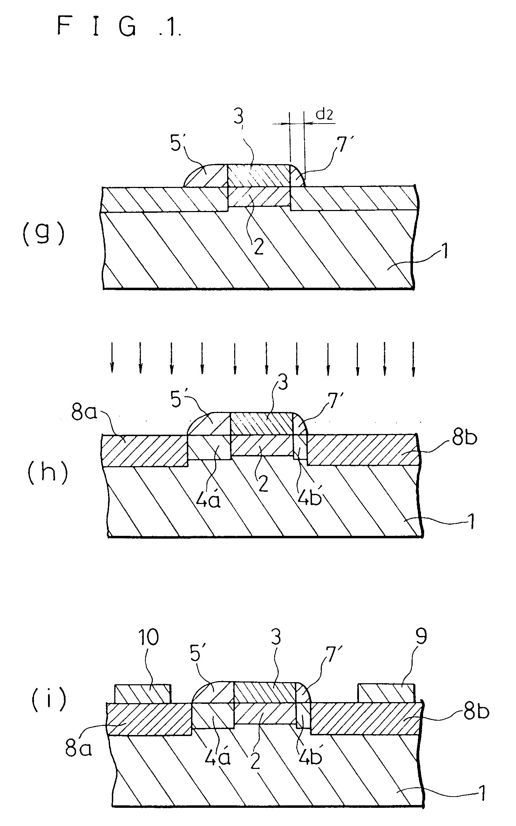

Figures 1(a) to (i) show cross-sectional side views in the major process steps of a production method of a semiconductor device according to a first embodiment of the present invention. In figure 1, the same reference numerals designate the same or corresponding elements as those shown in figure 4. Reference numerals 4a and 4b (4a' and 4b') designate n' type intermediate concentration active layers. Reference numeral 5 (5') designates first insulating film. Reference numeral 7 (7') designates second insulating film.

The production process will be described.

First of all, as shown in figure 1(a), an n type active layer 2 of 1000 to 2000 angstroms thickness is produced by conducting ion implantation into a semi-insulating GaAs substrate 1 using ²⁹Si⁺ ions, at conditions of implantation energy of 50 KeV, and impurity concentration of 1 × 10¹² cm⁻ ² or by conducting epitaxy growth. Thereafter, refractory metal such as WSiₓ is plated on the entire surface of wafer to a thickness of 3000 angstroms by a sputtering deposition method, and it is patterned by reactive ion etching with using photoresist as a mask, thereby producing a refractory metal gate 3 of about 1 micron gate length.

Next, as shown in figure 1(b), ²⁹Si⁺ ions are ion implanted at implantation energy of 50 KeV and impurity concentration of 1 × 10¹² cm⁻² with using the refractory metal gate 3 as a mask, thereby producing n' type active layers 4a and 4b at the both sides of the gate 3.

Next, as shown in figure 1(c), a first insulating film 5 comprising SiOₓ (x = 1 to 2) is deposited to a thickness of 8000 to 10000 angstroms by conducting such as plasma CVD using mixed gas of SiH₄ + N₂O.

Furthermore, as shown in figure 1(d), the entire surface of wafer is etched by reactive ion etching with using a mixed gas of C₂F₆, CF₄, CHF₃ + O₂, and further, an over-etching is conducted exceeding the etching conclusion point to a degree of about 10 to 30 %, thereby producing side wall assist films 5' of about 5000 angstroms width comprising the first insulating film 5, at the both side walls of the gate 3.

Next, as shown in figure 1(e), photoresist 6 is patterned so as to mask the side wall assist film 5' at the side where a drain electrode is to be produced, and the side wall assist film 5' at the side where a source electrode is to be produced is removed by such as buffered fluoric acid (HF + NH₄F + H₂O) with using the photoresist 6 as a mask.

Thereafter, as shown in figure 1(f), the photoresist 6 is removed by O₂ asher or organic series solution, and the second insulating film 7 comprising SiOₓ (x = 1 to 2) is plated on the entire surface of substrate to a thickness of about 3000 angstroms by such as plasma CVD method with using mixed gas of SiH₄ + N₂O.

Furthermore, as shown in figure 1(g), the entire surface of wafer is over-etched exceeding the etching conclusion point to a degree of 10 to 30 % by reactive ion etching using a mixed gas of C₂F₆, CF₄, CHF₃ + O₂, and the side wall assist film 5' of about 5000 angstroms width comprising the first insulating film 5 and the side wall assist film 7' of about 2000 angstroms width comprising a second insulating film 7 are produced at the side walls of the gate 3.

Next, as shown in figure 1(h), ²⁹Si⁺ ions are implanted into the substrate at implantation energy of 60 KeV and impurity concentration of 2 × 10¹³ cm⁻² with using the side wall assist films 5' and 7' and the refractory metal gate 3 as a mask, thereby producing n⁺ type high concentration active layers 8a and 8b at asymmetrical positions at left and right with respect to the gate 3.

Thereafter, an annealing process is conducted at 800 °C and for 30 minutes, and as shown in figure 1(i), a source electrode 9 comprising Ni/Ge/Au from below is produced on the n⁺ type high concentration active layer 8b at the side where the side wall assist film 7' is produced as well as a drain electrode 10 is produced on the n⁺ type high concentration active layer 8a at the opposite side by deposition and lift-off method at the same time, thereby completing a field effect transistor.

The advantages of the present invention over the above-described two prior arts will be described.

First of all, influences affected on the transistor characteristics by the precision of the pattern production will be described.

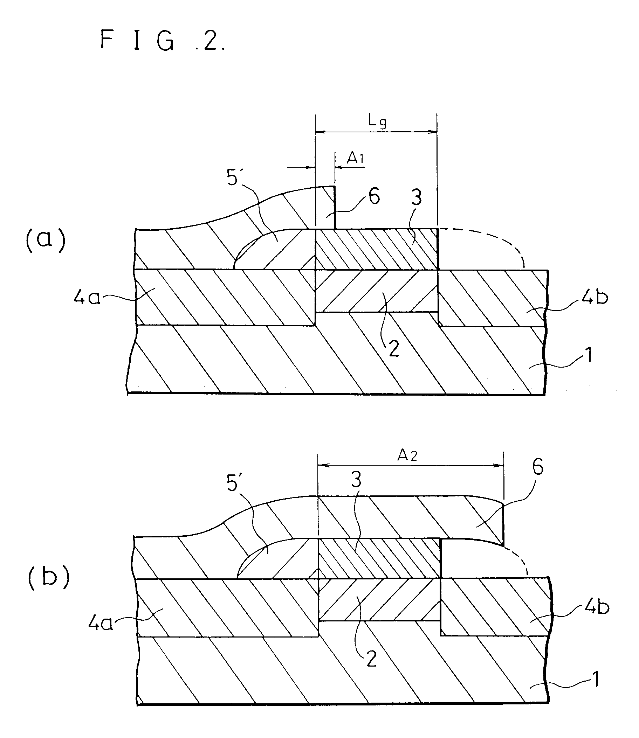

As shown in figure 4(c), in the first prior art, the distance between the gate 3 and the n⁺ type high concentration active layer 8a at the drain side is determined by the variations in the precision of pattern alignment of the photoresist 6. To the contrary, in the present invention, as shown in figures 2(a) and (b), the photoresist 6 only requires to be patterned such that the end surface comes to the position up to A₁ ∼ A₂ from the end of the gate 3 so as to cover the side wall assist films 5' at the side where a drain electrode is to be produced, and as far as the end surface of the photoresist is held in this range, the result of the etching of the side wall assist films 5' at the side where a source electrode is to be produced is the same.

Herein, the value of A₁ is required to be such a value that the side wall assist film 5' at the side where a drain electrode is to be produced is not eroded by permeating the buffered fluoric acid into the interface between the photoresist 6 and the refractory metal gate 3 at the step of soaking the device in buffered fluoric acid. In the experiment, 0.3 micron is obtained therefor. Therefore, this method can be applied to a case where the gate length Lg is above 0.3 microns.

Furthermore, the value of A₂ is only required to be such a value that the photoresist 6 does not cover the side wall assist film 5' which is to be etched. Furthermore, since the side wall assist film 5' at the drain side is completely covered by the photoresist 6 and the gate 3 when the side wall assist film 5' at the source side is removed by etching, there arises no problem such as side etching in the second prior art, and the side wall assist film 5' can be remained at one side of the gate 3 at high controllability and high reproducibility.

As for the film thickness of the photoresist 6, in the first prior art shown in figure 4(c), in order to make the photoresist 6 function as a mask for ion implantation into the n⁺ type high concentration active layer, the film thickness larger than the range of ion is required. For example, when ²⁹Si⁺ ions are implanted at 60 KeV, a photoresist having a film thickness of about 5000 angstroms is required, and the photoresist 16 having a film thickness of about 1 micron is actually used. To the contrary, in this embodiment, the photoresist is only required to have a thickness capable of being resistant to the etching by fluoric acid. Generally, the etching rate of photoresist to the buffered hydrofluoric acid (mixture of buffer solution and hydrogen fluoride in a ratio of 6 : 1) is several tens A/min, and it can be ignored in practical use. Therefore, in this embodiment, the photoresist film thickness is only required to be about 1000 angstroms while it is required to be about 1 micron in the prior art. The fact that such thin photoresist can be used results in a high resolution. Thus, the present invention is advantageous in view of patterning.

Furthermore, in this embodiment, as shown in figures 1(f) to (g), in the process of producing insulating films in asymmetrical configurations at left and right at the side walls of gate 3 by etching, since the film thicknesses of the insulating film 7 are equal to each other at the both sides of the gate 3, the times required for just-etching the insulating films 7 are equal to each other at the left and right sides of the gate, thereby enabling to produce the side wall assist films 5' and 7' at high controllability and at high reproducibility.

The above-described photoresist may be any type of photosensitive resin. For example, photosensitive polyimide may be used.

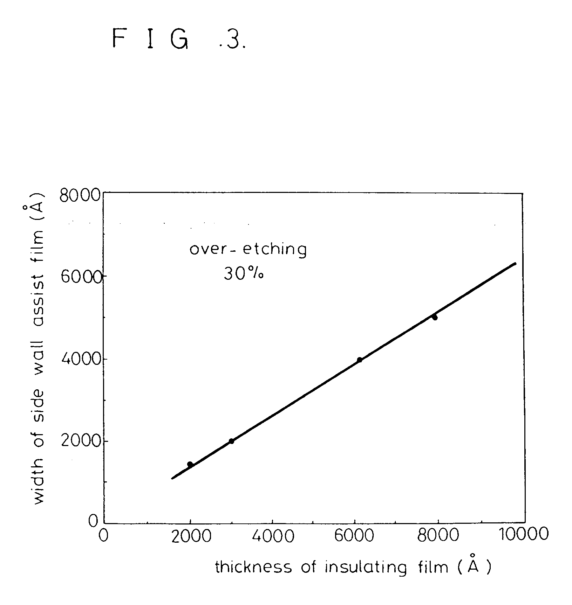

The controllability of the width d₁ and d₂ of the side wall assist films 5' and 7' shown in figures 1(d) and (g) will be described. The widths d₁ and d₂ can be controlled by varying the thicknesses of the first insulating film 5 and the second insulating film 7 which are plated in the processes shown in figures 1(c) and (f), respectively. Figure 3 shows the relationship between the thickness of the insulating film and the width of the side wall assist film when the over etching of 30% is conducted. As seen from the figure, the width of the side wall assist film is in direct proportional to the thickness of the insulating film, and this means that the widths d₁ and d₂ can be determined at quite high controllability. Accordingly, d₁ and d₂ may be determined in accordance with required breakdown voltage between gate and drain and that between gate and source. For example, in a case where d₁ is 5000 angstroms as shown in the above-described embodiment, the gate-drain breakdown voltage is 20 V, while in a case where d₂ is 2000 angstroms, the gate-source breakdown voltage is about 7 V. This high controllability of d₁ and d₂ brings about the stability of mutual conductance gₘ which is a characteristics of a transistor, thereby enabling to produce a high performance element at high precision.

While in the above-illustrated embodiment a semi-insulating GaAs substrate is used, the present invention may be applied to a field effect transistor using other compound semiconductor with the same effects as described above.

While in the above-illustrated embodiment the first insulating film 5 and the second insulating film 7 comprise SiOₓ, the insulating films may not be restricted thereto and they are only required to be produced in configurations shown in figure 1(c) or (f) by plasma CVD. For example, SiN or AlN may be used.

While in the above-illustrated embodiment the side wall assist films 5' and 7' are remained after the ion implantation, these side wall assist films may be removed by such as fluoric acid after the ion implantation process.

While in the above-illustrated embodiment the intermediate concentration active layers 4a' and 4b' are produced at below the side wall assist films 5' and 7' thereby to produce an LDD structure field effect transistor, the present invention may not be restricted to this structure. That is, the process of figure 1(b) may be removed, and high concentration active regions 8a and 8b may be produced without providing intermediate concentration active layers.

As is evident from the foregoing description, according to the present invention, side wall assist films are produced at both side walls of refractory metal gate in asymmetrical configurations at left and right, and high concentration active layers are self-alignedly produced at asymmetrical positions at left and right by conducting ion implantation with using the side walls as a mask. Therefore, variations in the gate-drain breakdown voltage and the source-gate breakdown voltage and variations in the transistor performances can be reduced, thereby enabling to produce a field effect transistor having a stable transistor breakdown voltage and stable performances at high precision and at high reproducibility.

## Claims

1. A Schottky barrier gate type field effect transistor comprising:
a gate electrode (3) comprising refractory metal on a semi-insulating compound semiconductor substrate (1);
a low concentration active channel region (2) produced in said substrate (1)below said gate electrode (3);
high concentration active regions (8a,8b) produced respectively each side of said low concentration active channel region (2);
a source electrode (9) produced on one (8b) of said high concentration active regions (8a,8b), near to said gate electrode (3); and
a drain electrode (10) produced on the other (8a) of said high concentration active regions (8a,8b), provided near to the side of the gate electrode (3) opposite to that of said source electrode (9);
which transistor is characterised by:
intermediate concentration active regions (4a',4b') in asymmetrical configuration respectively at the left and the right of said active channel region (2) in said substrate (1) between said active channel region (2) and said high concentration active regions (8a,8b).

2. A transistor as claimed in claim 1 including side wall films (5',7') in asymmetrical configuration respectively each side of said gate electrode (3) above said intermediate concentration active regions (4a',4b').

3. A semiconductor device as defined in claim 2, wherein said side wall films (5',7') comprise Si0ₓ, SiN, or AlN.
